# EUROPEAN PATENT APPLICATION

(11) **EP 3 769 878 A1**
(43) Date of publication of application: **27.01.2021**
(21) Application number: 19772148.3
(22) Date of filing: 15.03.2019
(51) Int. Cl.: B23B 27/14, C23C 16/36, C23C 16/40

(54) **INSERT AND CUTTING TOOL PROVIDED WITH SAME**

(30) Priority: 20.03.2018 JP 2018052842; 29.11.2018 JP 2018223528
(71) Applicant: Kyocera Corporation, Kyoto-shi, Kyoto 612-8501 (JP)
(72) Inventor: TANAKA,Ayano, Kyoto-shi, Kyoto 612-8501 (JP); NOMIYAMA,Ryoma, Kyoto-shi, Kyoto 612-8501 (JP)
(74) Representative: Viering, Jentschura & Partner mbB Patent- und Rechtsanwälte
(86) International application number: PCT/JP2019/010879
(87) International publication number: WO 2019/181794

(57) **Abstract**

An insert of the present disclosure includes a base and a coating layer covering a surface of the base. The base includes a hard phase containing a carbonitride including Ti and a binder phase containing Co. A first compound that contains Co, C, and W whose contents in atm% satisfy a relation of Co > C > W is positioned between the base and the coating layer. A cutting tool of the present disclosure includes a holder extending from a first end to a second end and having a pocket on the first end side, and the insert positioned in the pocket positioned.

## Description

### Field

The present disclosure relates to an insert for use in a cutting process and a cutting tool including the same.

### Background

Cermets including titanium (Ti) as a main component are now widely used as bases of members requiring wear resistance, sliding property, and chipping resistance, such as cutting tools, wear-resistant members, and sliding members.

For example, Patent Literature 1 discloses a surface-coated titanium carbonitride-based cermet cutting tool, in which a binder phase component based on cobalt (Co) and nickel (Ni) is contained, an erosion alloy phase composed of a metal binder phase component is formed on a surface portion, and a TiN layer having a diffusion-preventing effect is additionally provided thereon to suppress fracture or chipping.

### Citation List

### Patent Literature

Patent Literature 1: Japanese Patent No. 5989930 Summary

An insert of the present disclosure includes a base and a coating layer covering a surface of the base. The base includes a hard phase containing a carbonitride including Ti and a binder phase containing Co. A first compound that contains Co, C, and W whose contents in atm% satisfy a relation of Co > C > W is positioned between the base and the coating layer. A cutting tool of the present disclosure includes a holder extending from a first end to a second end and having a pocket on the first end side, and the aforementioned insert positioned in the pocket.

### Brief Description of Drawings

FIG. 1 is a perspective view illustrating an example of an insert of the present disclosure.
FIG. 2 is an enlarged schematic diagram of a cross section in the vicinity of a surface of the insert of the present disclosure.
FIG. 3 is an enlarged schematic diagram of a cross section in the vicinity of the surface of the insert of the present disclosure according to other embodiments.
FIG. 4 is an enlarged schematic diagram of a cross section in the vicinity of the surface of the insert of the present disclosure according to other embodiments.
FIG. 5 is an enlarged schematic diagram of a cross section in the vicinity of the surface of the insert of the present disclosure according to other embodiments.
FIG. 6 is an enlarged schematic diagram of a cross section in the vicinity of the surface of the insert of the present disclosure according to other embodiments.
FIG. 7 is an enlarged schematic diagram of a cross section in the vicinity of the surface of the insert of the present disclosure according to other embodiments.
FIG. 8 is an enlarged schematic diagram of a cross section in the vicinity of the surface of the insert of the present disclosure according to other embodiments.
FIG. 9 is a plan view illustrating an example of a cutting tool of the present disclosure.

### Description of Embodiments

### <Insert>

An insert of the present disclosure will be described in detail below with reference to the drawings. The drawings hereinafter referred to are simplified to illustrate only the main members necessary for describing embodiments, for convenience of description. The insert of the present disclosure may include any components not illustrated in the drawings referred to. The dimensions of members in the drawings do not exactly represent the actual dimensions of components or dimensional ratio between members. These points are applicable to a cutting tool described later.

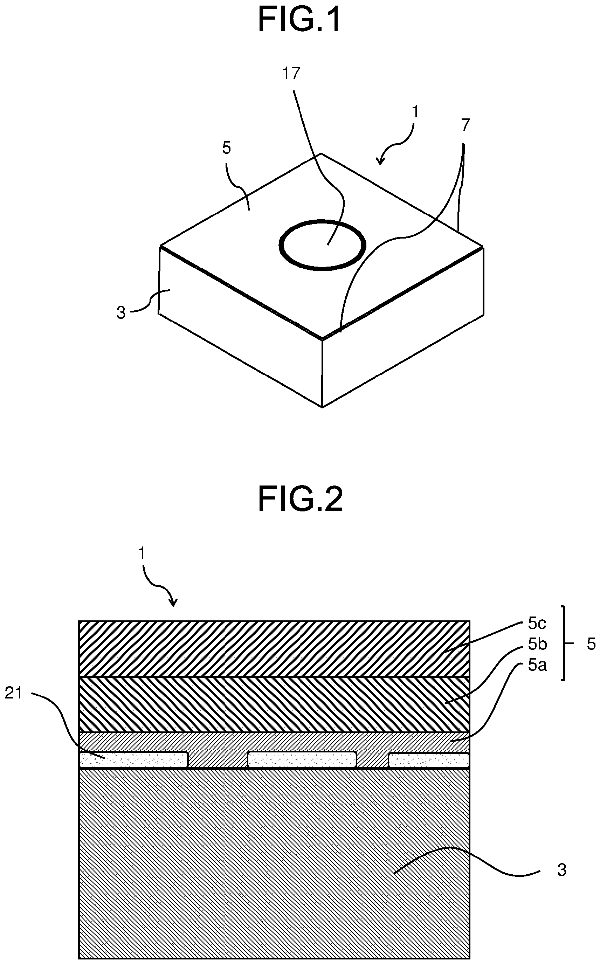

As illustrated in FIG. 1 and FIG. 2, an insert 1 of the present disclosure includes a base 3. The insert 1 of the present disclosure includes a coating layer 5 covering at least a part of the base 3.

The insert 1 of the present disclosure has, for example, a quadrangular plate shape, and its upper surface in FIG. 1 is a rake face. The insert 1 has a lower surface on the side opposite to the upper surface and a side surface between the upper surface and the lower surface to connect to each of the upper and lower surfaces. At least a part of the side surface is a flank face.

The insert 1 of the present disclosure has a cutting edge 7 positioned at at least a part of a ridge line where the upper surface and the side surface intersect. In other words, the insert 1 has the cutting edge 7 positioned at at least a part of a ridge line where the rake face and the flank face intersect.

In the insert 1, the entire outer perimeter of the rake face may serve as the cutting edge 7. However, the insert 1 is not limited to such a configuration and, for example, may have the cutting edge 7 at only one side, or partially, of the quadrangular rake face.

The size of the insert 1 is not limited and, for example, the length of one side of the rake face is set to about 3 to 20 mm. The thickness of the insert 1 is set, for example, to about 1 to 20 mm.

The base 3 of the insert 1 of the present disclosure is composed of a cermet containing a hard phase containing a carbonitride including Ti and a binder phase containing Co. The cermet is a TiCN-based cermet. Specifically, examples of the cermet include, but are not limited to, those containing TiC or TiN, etc., in addition to TiCN.

As illustrated in FIG. 2, the insert 1 of the present disclosure includes the coating layer 5 on the base 3. Since the insert 1 thus includes the coating layer 5, the wear resistance of the insert 1 is high.

The coating layer 5 may be formed, for example, by a CVD process or a PVD process. In the coating layer 5, for example, a first layer 5a including a plurality of TiN particles, a second layer 5b including a plurality of TiCN particles, and a third layer 5c including a plurality of Al₂O₃ particles may be disposed sequentially from the side close to the base 3.

In the insert 1 of the present disclosure, a first compound 21 containing Co, C, and W whose contents in atm% satisfy the relation of Co > C > W is positioned between the base 3 and the coating layer 5.

The insert 1 of the present disclosure having such a configuration has excellent wear resistance and chipping resistance.

The first compound 21 may contain 90 atm% or more of a total of Co, C, and W and contain 69 to 89 atm% of Co, 8 to 25 atm% of C, and 3 to 12 atm% of W.

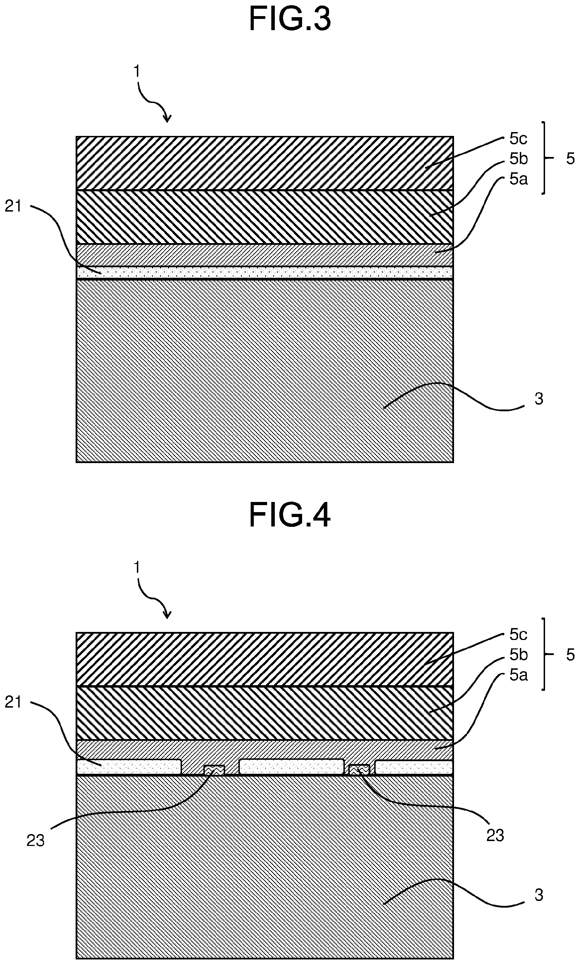

As illustrated in FIG. 2, the first compound 21 may cover a part of the base 3. The first compound 21 may cover 80% or more of the base 3 in a part in which the coating layer 5 is present. As illustrated in FIG. 3, the first compound 21 may cover all of the base 3 in a part in which the coating layer 5 is present.

As illustrated in FIG. 4, a second compound 23 containing C, Co, and W whose contents in atm% satisfy the relation of C > Co > W may be positioned between the base 3 and the coating layer 5, in addition to the first compound 21.

The second compound 23 may contain 90 atm% or more of a total of C, Co, and W and contain 60 to 75 atm% of C, 18 to 30 atm% of Co, and 2 to 10 atm% of W.

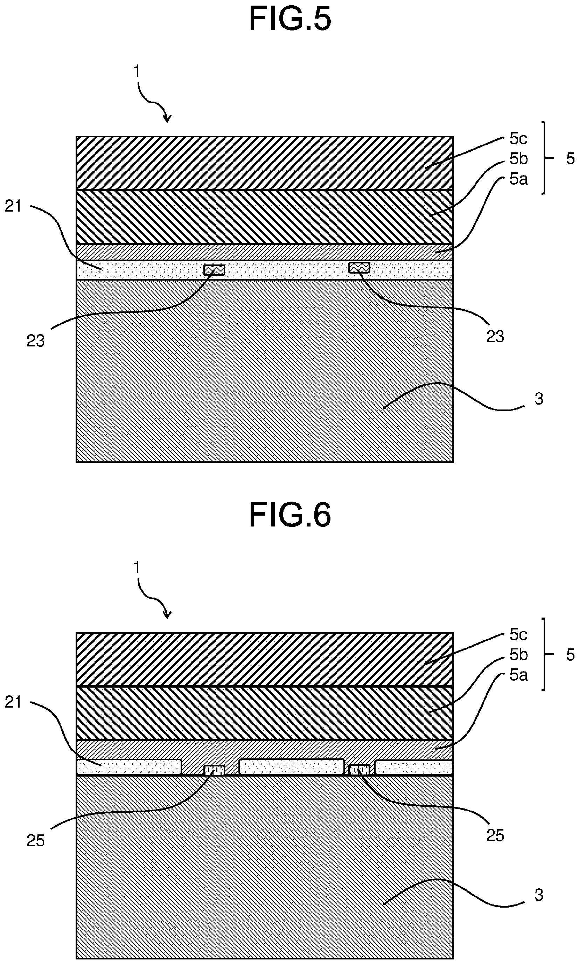

As illustrated in FIG. 5, the first compound 21 may surround the second compound 23 in a cross-sectional view.

As illustrated in FIG. 6, a third compound 25 containing C, Ti, and W whose contents in atm% satisfy the relation of C > Ti > W may be positioned between the base 3 and the coating layer 5, in addition to the first compound 21.

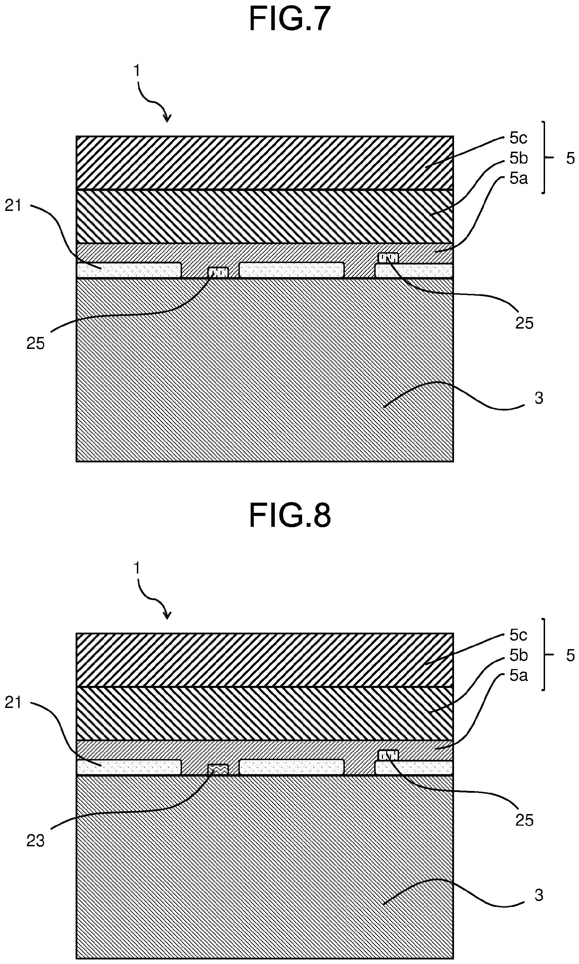

As illustrated in FIG. 7, the third compound 25 may be positioned between the first compound 21 and the coating layer 5 in a cross-sectional view.

As illustrated in FIG. 8, the first compound 21, the second compound 23, and the third compound 25 may be positioned between the base 3 and the coating layer 5.

The third compound 25 may contain 80 atm% or more of a total of C, Ti, and W and contain 58 to 80 atm% of C, 7 to 25 atm% of Ti, and 1 to 15 atm% of W.

The insert 1 of the present disclosure having the first compound 21 described above is excellent in wear resistance and chipping resistance.

The base may contain Co_{0.93}W_{0.07}. Thereby, the insert 1 excellent in wear resistance and fracture resistance can be obtained. Co_{0.93}W_{0.07} is a crystal represented in PDF: 01-071-7509 of the JCPDS card.

In the insert 1 of the present disclosure, the proportion of the Co_{0.93}W_{0.07} in all the crystals may be 5 to 10 in a crystalline phase analysis by X-ray diffraction. The proportion of Co_{0.93}W_{0.07} may be 8 to 10. When the Co_{0.93}W_{0.07} content is thus high, the wear resistance and the fracture resistance of the base 3 are high.

The proportion of the Co_{0.93}W_{0.07} described above is obtained by calculating the proportion of Co_{0.93}W_{0.07} in the proportions of all the crystals detected by a Riedveld method using an X-ray system produced by PANalytical, X'Pert Pro 2θ: 10 to 100, and analysis software RIETAN-FP.

In the insert 1 of the present disclosure, the Co content in the total amount of the binder phase may be 99.0 mass% or more. The Co content may be 99.5 mass% or more. Fe, Ni, and the like may be included in the binder phase, in addition to Co. When the binder phase includes Co, Fe, and Ni, the Co content (mass%) is a value obtained by measuring the masses of Co, Fe, and Ni included in the insert, dividing the mass of Co by the total mass, and multiplying it by 100. In other words, the total amount of Fe and Ni in the binder phase included in the insert 1 of the present disclosure may be less than 1 mass%. When a metal functioning as a binder phase is thus substantially Co alone, Co_{0.93}W_{0.07} is distributed in the base 3 adequately and the base 3 having high wear resistance and fracture resistance is easily obtained. When the binder phase is Co alone, for example, the mean particle size as a raw material powder of the hard phase may be 1 µm or less, and further, 0.6 µm or less. The Co content in the base 3 may be 16 mass% or more.

When Fe and Ni are included in the binder phase, the wettability between the hard phase and the binder phase is improved.

In a cross section of the first layer 5a vertical to a surface of the base 3, the width of TiN particles in a direction parallel to the surface of the base 3 (hereinafter also referred to as the width of TiN particles) may be 25 nm. With such a configuration, the adhesion of the first layer 5a to the base 3 is excellent. The adhesion between the first layer 5a and the first compound 21, between the first layer 5a and the second compound 23, and between the first layer 5a and the third compound 25 is excellent. The coating film 5 is excellent in wear resistance.

The width of TiN particles may be measured at a position of 0.05 µm from the surface of the base 3. When the base 3 is covered with the first compound 21, the width of TiN particles may be measured at a position of 0.05 µm from the surface of the first compound 21. When the thickness of the first layer 5a is 0.05 µm or less, the width of TiN particles may be measured at a position of half the thickness of the first layer 5a.

The width of TiN particles is the mean value of the widths of 20 TiN particles measured at the position described above.

In a cross section vertical to the surface of the base 3, the ratio (which hereinafter may be referred to as aspect ratio) of the height of TiN particles in a direction vertical to the surface of the base to the width of TiN particles in a direction parallel to the surface of the base 3 may be within a range of 1.0 to 1.7. With such a configuration, the adhesion force between the first layer 5a and the base 3 is excellent.

The aspect ratio of TiN particles may be measured for TiN particles present at a position of up to 0.05 µm from the surface of the base 3. The aspect ratio is the mean value of 20 TiN particles.

The thickness of the first layer 5a may be 0.1 to 1.0 µm. When the thickness of the first layer 5a is 0.1 µm or more, diffusion of the binder phase component included in the base 3 to the coating is suppressed, and the chipping resistance is excellent. When the thickness of the first layer 5a is 1.0 µm or less, the upper layer, that is, the second layer 5b is finer, and the wear resistance is excellent. In particular, the thickness of the first layer 5a may be 0.3 to 0.7 µm.

When the thickness of the first layer 5a is 0.1 µm or more, diffusion of the binder phase component included in the base 3 to the coating is suppressed, and the chipping resistance is excellent. Diffusion of the binder phase component included in the base 3 to the coating is suppressed, and the chipping resistance is excellent. When the thickness of the first layer 5a is 1.0 µm or less, the TiCN particles included in the upper layer, that is, the second layer 5b are finer, and the wear resistance is excellent.

In the example illustrated in FIG. 2, the insert 1 includes the first layer 5a on the base 3. The insert 1 includes the second layer 5b on the first layer 5a. The second layer 5b includes TiCN particles that are TiCN crystals. The thermal expansion coefficient of the TiCN crystals is about 8 × 10⁻⁶/°C, and when the thermal expansion coefficient of the base 3 is 9.0 × 10⁻⁶/°C or more, the thermal expansion coefficient of the second layer 5b is smaller than the thermal expansion coefficient of the base 3. The second layer 5b is interposed between the base 3 and the first layer 5c to suppress peeling of the first layer 5c and suppress abrasive wear.

The third layer 5c includes Al₂O₃ particles that are Al₂O₃ crystals. The thermal expansion coefficient of the Al₂O₃ crystals is about 7.2 × 10⁻⁶/°C and is smaller than the thermal expansion coefficients of the base 3 and the second layer 5b. The base 3 and the second layer 5b may be in direct contact or, for example, the first layer 5a may be positioned between them as in the example in FIG. 2. The first layer 5a is not necessarily composed of pure TiN particles and may contain, for example, O and/or C. The second layer 5b and the third layer 5c may be in direct contact or, for example, a TiN layer (not illustrated) may be positioned between them.

In the insert 1 having such a configuration, an adequate compressive stress can be applied to the second layer 5b and the third layer 5c by adjusting the thermal expansion coefficient of the base 3 and the thickness of the third layer 5c. For example, the thickness of the third layer 5c is 2 µm or more.

Then, the compressive stress applied to the second layer 5b may be 250 to 500 MPa, the compressive stress applied to the third layer 5c may be 450 MPa or more, and the value of the compressive stress applied to the third layer 5c may be larger than the compressive stress applied to the second layer 5b. The insert 1 having such a configuration is excellent in wear resistance and durability.

The compressive stresses applied to the second layer 5b and the third layer 5c may be determined based on measurement using a 2D process. Specifically, a section of the flank face, 1 mm or more away from the cutting edge 7, is set as a measurement location, and X-ray diffraction peaks are measured. For the crystal structure specified from the measurement result, the compressive stress can be obtained by determining how the value of 2θ in the measurement result deviates from the value of 2θ serving as a standard described in the JCPDS card.

When a residual stress has a negative value, the residual stress is compressive stress. When the value of compressive stress is expressed, it is represented by an absolute value with no minus sign.

As the thermal expansion coefficient of the base 3 increases, the values of the compressive stresses applied to the second layer 5b and the third layer 5c tend to increase.

When the second layer 5b and the third layer 5c that constitute the coating layer 5 are compared, the third layer 5c is at a position more distant from the base 3. When a workpiece is processed using the cutting tool 1 having such a configuration, therefore, the third layer 5c comes into contact with the workpiece before the second layer 5b. When the third layer 5c includes Al₂O₃ particles and has a thickness of 2 µm or more, the wear resistance and the oxidation resistance are high. The thickness of the third layer 5c may be 2.5 µm or more and 8.0 µm or less. The insert 1 having such a configuration is more excellent in wear resistance and oxidation resistance.

In consideration of the functions of the second layer 5b and the third layer 5c, the sum of the thickness of the second layer 5b and the thickness of the third layer 5c may be 7 µm or more and 18 µm or less. The sum of the thicknesses may be 8 µm or more and 16 µm or less.

The second layer 5b may have a thickness of 5 µm or more and 10 µm or less. With such a range, the wear resistance and the chipping resistance of the insert 1 are excellent.

The thickness of the third layer 5c may be 0.2 to 0.4 times the sum of the thickness of the second layer 5b and the thickness of the third layer 5c. The insert 1 having such a configuration is excellent in wear resistance and chipping resistance.

The C axis of the Al₂O₃ crystals of the third layer 5c may be oriented along a direction vertical to a main surface of the base 3. In other words, the third layer 5c may contain α-Al₂O₃ crystals, and the α-Al₂O₃ crystals may be shaped into a column extending in the vertical direction relative to the main surface of the base 3. In the base 3 in the insert 1 of the present disclosure, a binder-phase-enriched layer that contains a hard phase and a binder phase and has a higher proportion of the binder phase compared with the inside of the base 3 may be present on the surface. The thickness of this binder-phase-enriched layer may be 1 µm or more and 10 µm or less.

A method of producing the insert of the present disclosure will be described below.

Table 1 illustrates the proportions of raw material powders to form the base of the insert used in Examples described later. The mean particle size of each raw material is 1 µm or less. These raw material powders are typically used in production of cermets.

The insert of the present disclosure can be obtained by controlling the composition of the base and the production condition of the coating layer. In order to produce the first compound between the base and the coating layer, the proportion of Co in the binder phase included in the base may be set to 97.0 mass% or more, and the amount of Co included in the base may be set to 10 mass% or more. The proportion of Co in the binder phase included in the base may be 99.0 mass% or more and further may be 99.9 mass% or more. The proportion of Co is a value obtained by measuring the masses of Co, Fe, and Ni included in the insert and dividing the mass of Co by the total mass. This can be represented by a formula Co/(Co + Ni + Fe).

When the amount of a binder phase included in the base is 16 mass% or less, the first compound covers a part of the base. When the amount of a binder phase included in the base exceeds 16 mass%, the first compound covers all of the base covered with the coating layer.

After a binder is added to the raw material powder having such a composition range, for example, the powder is formed into a desired shape by press molding and subjected to a degreasing step for removing the binder component, and thereafter, fired in a nitrogen or vacuum atmosphere within a temperature range of 1500 to 1550°C to produce a highly dense base.

At the degreasing step, the product is held in a vacuum at 200°C and 300°C each for 1 hour, and then the temperature is increased to 450°C and held for 1 hour. At the step at 450°C, in order to suppress reduction of C added to a raw material, CO₂ gas is introduced into a degreasing furnace at a pressure of 1 to 5 kPa. Thus, the amount of C can be precisely controlled.

The base may have a thermal expansion coefficient at 25 to 1000°C of 9.0 × 10⁻⁶/°C or more.

Subsequently, a coating layer is provided. When a coating layer is provided, for example, a first layer including a plurality of TiN particles is formed on a surface of the base. A second layer including a plurality of TiCN particles is further formed on the first layer. A third layer including a plurality of Al₂O₃ particles is further formed thereon. The first layer, the second layer, and the third layer may be formed by a chemical vapor deposition (CVD) process. With this CVD process, the higher the deposition temperature is in depositing a film, the greater the compressive stress is applied to the deposited film. The deposition temperature is then adjusted, if necessary.

In order to obtain the first layer including fine TiN particles with a width less than 25 nm in a direction parallel to the surface of the base, the ratio of Co in the binder phase components included in the base may be set to 99.0 mass% or more.

The first layer may be deposited, for example, at a temperature of 800 to 900°C, a pressure of 8 to 20 kPa, a TiCl₄ concentration of 0.2 to 2.5 mol%, a N₂ concentration of 25.0 to 49.9 mol%, and a H₂ concentration of 40.0 to 74.8 mol%.

In order to produce the second compound between the base and the coating layer, the amount of C in the raw materials and the amount of a hard phase in the raw material composition of the base may be adjusted such that C/hard phase is 8.0 or more. The amount of C in the raw materials includes, for example, C included in the raw material powders, in addition to C added as carbon. The hard phase refers to the one that may be present as a hard phase in an insert and does not include, for example, metals, oxides, or carbonates of Fe, Ni, Co, Mn, and/or Mo.

In order to cover the second compound with the first compound, the amount of a binder phase included in the base may exceed 16 mass%, and the C/hard phase may be set to 8.0 or more.

In order to produce the third compound between the base and the coating layer, the TiCl₄ concentration in the deposition condition for forming the first layer on the base may be set to 1.0 mol% or more. When the TiCl₄ concentration is set to 1.2 mol% or more, the insert having the third compound positioned between the first compound and the coating layer can be obtained.

Alternatively, the first compound, the second compound, and the third compound prepared preliminarily may be attached to the surface of the base as desired, and thereafter, a coating film may be formed to produce the insert of the present disclosure.

### <Cutting Tool>

The cutting tool of the present disclosure will now be described with reference to the drawings.

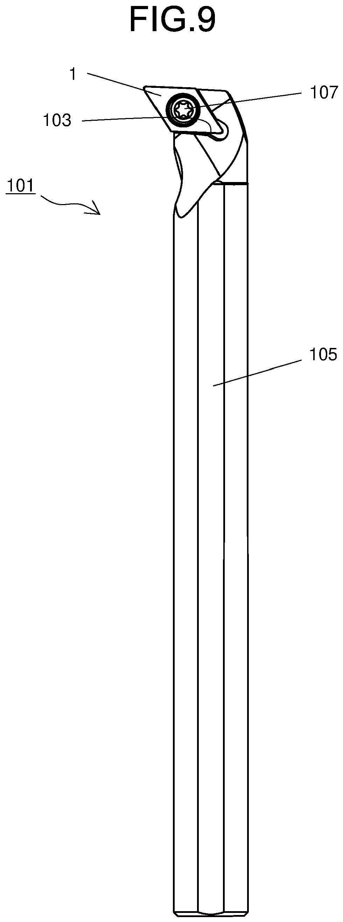

As illustrated in FIG. 9, a cutting tool 101 of the present disclosure is, for example, a rod-shaped body extending from a first end (the upper end in FIG. 9) to a second end (the lower end in FIG. 9). As illustrated in FIG. 9, the cutting tool 101 includes a holder 105 having a pocket 103 on the first end side (tip end side) and the aforementioned insert 1 positioned in the pocket 103. The cutting tool 101 includes the insert 1, and hence, can perform a stable cutting process over a long time period.

The pocket 103 is a portion to which the insert 1 is attached and has a seat surface parallel to a lower surface of the holder 105 and a constraint side surface inclined relative to the seat surface. The pocket 103 is open on the first end side of the holder 105.

The insert 1 is positioned in the pocket 103. The lower surface of the insert 1 may be in direct contact with the pocket 103, or a sheet (not illustrated) may be sandwiched between the insert 1 and the pocket 103.

The insert 1 is attached to the holder 105 such that at least a part of a section used as the cutting edge 7 at the ridge line on which the flank face and the rake face intersect protrudes outward from the holder 105. In the embodiments, the insert 1 is attached to the holder 105 by a fixing screw 107. That is, the insert 1 is attached to the holder 105 by inserting the fixing screw 107 into a through-hole 17 of the insert 1, inserting the tip end of the fixing screw 107 into a screw hole (not illustrated) formed in the pocket 103, and screwing the screw portions together.

For example, steel and cast iron can be used as the material of the holder 105. Among these materials, steel with a high toughness may be used.

In the embodiments, the cutting tool 101 for use in a turning process is illustrated by way of example. Examples of the turning process include, but are not limited to, a boring process, an external process, a grooving process, and a facing process. The cutting tool 101 is not limited to the one for use in the turning process. For example, the insert 1 in the embodiments may be used for the cutting tool 101 for use in a milling process.

### Examples

The insert of the present disclosure will be described below.

The base was produced as follows. A molded product in the shape of a tool was produced using raw material powders in proportions indicated in Table 1, and a binder component was removed, followed by firing to produce a base. Among these samples, the bases of Sample Nos. 1 to 14 were a cermet. The base of Sample No. 15 was a superalloy. At the degreasing step, the product was held in a vacuum at 200°C and 300°C each for 1 hour, and then the temperature was increased to 450°C and held for 1 hour. At the step at 450°C, CO₂ gas was introduced at a pressure of 3 kPa into a degreasing furnace.

When the surfaces of the bases obtained through a firing step were observed, the first compound, the second compound, or the third compound was not found in any of the bases.

**Table 1**

| Sample No. | Base | | | | | | | | | | | | | | |
|---|---|---|---|---|---|---|---|---|---|---|---|---|---|---|---|
| | Amount prepared [mass%] | | | | | | | | | | | Co/(Co+ Ni) (mass%) | C/(hard phase) [-] | Amount of Co_{0.93} w_{0.07} [%] | Thermal expansion coefficient [× 10⁻⁶ (/°C)] |
| | TiCN | TiN | WC | NbC | VC | Mo₂C | MnCO₃ | ZrC | Co | Ni | C | | | | |
| 1 | 28.2 | 17.8 | 20.9 | 7.9 | 1.6 | 0.6 | 0.8 | 0.2 | 15.0 | 4.9 | 2.1 | 75.4 | 9.20 | 0.0 | 9.26 |
| 2 | 28.3 | 17.8 | 21.0 | 7.9 | 1.6 | 0.6 | 0.8 | 0.2 | 20.0 | 0.0 | 1.8 | 100.0 | 8.90 | 2.6 | 9.32 |
| 3 | 28.5 | 18.0 | 21.2 | 8.0 | 1.6 | 0.6 | 0.8 | 0.2 | 20.1 | 0.0 | 1.0 | 100.0 | 7.90 | 7.6 | 9.30 |
| 4 | 42.2 | 16.6 | 19.4 | 8.6 | 1.6 | 0.6 | 0.8 | 0.2 | 9.0 | 0.0 | 1.0 | 100.0 | 8.28 | 1.2 | 9.10 |
| 5 | 41.8 | 10.0 | 21.1 | 7.9 | 1.6 | 0.6 | 0.8 | 0.2 | 16.0 | 0.0 | 0.0 | 100.0 | 8.40 | 2.3 | 9.18 |
| 6 | 46.8 | 10.0 | 21.0 | 8.0 | 1.6 | 0.6 | 0.8 | 0.2 | 6.0 | 5.0 | 0.0 | 54.5 | 7.57 | 0.0 | 9.20 |
| 7 | 41.2 | 8.3 | 21.0 | 7.9 | 1.6 | 0.6 | 0.8 | 0.2 | 18.2 | 0.0 | 0.3 | 100.0 | 8.33 | 3.8 | 9.28 |
| 8 | 40.0 | 8.1 | 20.4 | 7.7 | 1.6 | 0.6 | 0.8 | 0.2 | 20.6 | 0.0 | 0.3 | 100.0 | 8.34 | 9.8 | 9.31 |
| 9 | 40.0 | 8.1 | 20.4 | 7.7 | 1.6 | 0.6 | 0.8 | 0.2 | 20.6 | 0.0 | 0.3 | 100.0 | 8.34 | 9.8 | 9.31 |
| 10 | 40.0 | 8.1 | 20.4 | 7.7 | 1.6 | 0.6 | 0.8 | 0.2 | 20.5 | 0.1 | 0.3 | 99.5 | 8.34 | 8.4 | 9.33 |
| 11 | 40.0 | 8.1 | 20.4 | 7.7 | 1.6 | 0.6 | 0.8 | 0.2 | 20.0 | 0.6 | 0.3 | 97.1 | 8.34 | 5.1 | 9.35 |
| 12 | 57.2 | 7.5 | 14.6 | 0.0 | 0.0 | 0.0 | 0.0 | 0.0 | 20.7 | 0.0 | 0.0 | 100.0 | 8.23 | 10.9 | 9.02 |
| 13 | 56.3 | 7.5 | 14.6 | 0.0 | 0.0 | 0.0 | 0.0 | 0.0 | 21.6 | 0.0 | 0.0 | 100.0 | 8.21 | 12.1 | 9.06 |
| 14 | 55.4 | 7.5 | 14.6 | 0.0 | 0.0 | 0.0 | 0.0 | 0.0 | 22.5 | 0.0 | 0.0 | 100.0 | 8.19 | 14.6 | 9.17 |
| 15 | 0.0 | 0.0 | A | 0.0 | 0.0 | 0.0 | 0.0 | 0.0 | 10.0 | 0.0 | 0.0 | 100.0 | 6.13 | 0 | 6.08 |

On the surfaces of these bases, the first layer was formed under the deposition condition illustrated in Table 2 by a CVD process. The second layer was further formed on the first layer. The third layer was further formed on the second layer.

A cross section of the resulting insert was observed using a transmission electron microscope JEM-2010F (UHR) produced by JOEL Ltd. with a magnification of 80,000 to 200,000 to determine the presence/absence of the first compound, the second compound, and the third compound between the base and the coating layer. The shape of TiN particles in the first layer was measured. Whether the base contained Co_{0.93}W_{0.07} was determined by X-ray diffraction. The composition of each compound was determined by thin film quantitative analysis using the same device. The presence/absence of the first compound, the second compound, and the third compound in each sample is illustrated in Table 2. The bases had a binder-phase-enriched layer.

**Table 2**

| Sample No. | TiN layer deposition condition 850°C, 16kPa | | | Width of TiN particles (nm) | Compound | | | Compressive stress σ 11[MPa] | | Film thickness [µm] | | | Film thickness ratio | Cutting performance | |
|---|---|---|---|---|---|---|---|---|---|---|---|---|---|---|---|
| | H₂ concentration [mol.%] | N₂ concentration [mol.%] | TiCl₄ concentration [mol.%] | | First compound | Second compound | Third compound | | | | | | | Amount of flank face wear [µm] | Number of impacts until chipping occurs |
| | | | | | | | | TiCN | Al₂O₃ | TiCN | Al₂O₃ | TiCN+A l₂O₃ | Al₂O₃/ (Al₂O₃ +TiCN) | | |
| 1 | 49.7 | 49.7 | 0.6 | 56 | No | Yes | No | -301 | -511 | 7.78 | 3.52 | 11.30 | 0.31 | 90 | 15356 |
| 2 | 49.8 | 49.8 | 0.4 | 14 | Yes | Yes | No | -315 | -502 | 7.60 | 3.74 | 11.34 | 0.33 | 81 | 30013 |
| 3 | 49.1 | 49.1 | 1.8 | 15 | Yes | No | Yes | -349 | -498 | 7.41 | 3.87 | 11.28 | 0.34 | 84 | 31514 |
| 4 | 49.5 | 49.5 | 1.0 | 12 | No | Yes | Yes | -341 | -492 | 7.52 | 3.98 | 11.50 | 0.35 | 89 | 20341 |
| 5 | 49.5 | 49.5 | 1.0 | 12 | Yes | Yes | Yes | -296 | -483 | 7.57 | 4.01 | 11.58 | 0.35 | 72 | 38613 |
| 6 | 49.8 | 49.8 | 0.4 | 43 | No | No | No | -311 | -516 | 7.65 | 3.41 | 11.06 | 0.31 | 119 | 11742 |
| 7 | 49.7 | 49.7 | 0.6 | 13 | Yes | Yes | No | -342 | -513 | 7.43 | 3.56 | 10.99 | 0.32 | 76 | 31062 |
| 8 | 49.3 | 49.3 | 1.5 | 15 | Yes | Yes | Yes | -429 | -607 | 7.76 | 2.68 | 10.44 | 0.26 | 65 | 42917 |
| 9 | 49.9 | 49.9 | 0.3 | 15 | Yes | Yes | No | -422 | -599 | 7.15 | 3.23 | 10.38 | 0.31 | 78 | 35156 |
| 10 | 49.8 | 49.8 | 0.4 | 24 | Yes | Yes | No | -250 | -632 | 9.84 | 6.31 | 16.15 | 0.39 | 79 | 36134 |
| 11 | 49.8 | 49.8 | 0.4 | 35 | Yes | Yes | No | -203 | -553 | 11.74 | 2.06 | 13.80 | 0.15 | 81 | 29561 |
| 12 | 49.8 | 49.8 | 0.4 | 15 | Yes | Yes | No | -250 | -468 | 9.84 | 6.31 | 16.15 | 0.39 | 75 | 25313 |
| 13 | 49.8 | 49.8 | 0.4 | 17 | Yes | Yes | No | -271 | -632 | 8.61 | 1.82 | 10.43 | 0.17 | 84 | 23613 |
| 14 | 49.8 | 49.8 | 0.4 | 18 | Yes | Yes | No | -279 | -588 | 8.42 | 2.57 | 10.99 | 0.23 | 88 | 20641 |
| 15 | 49.8 | 49.8 | 0.4 | 39 | No | No | No | 509 | 531 | 7.29 | 3.45 | 10.74 | 0.32 | 196 | 20086 |

In Sample No. 15 using a superalloy as a base, none of the first compound, the second compound, and the third compound was found.

Sample Nos. 2, 3, 5, and 7 to 14 in which the proportion of Co in the binder phase (Ni + Co) was 97.0 mass% or more and the proportion of Co in the base was 10 mass% or more had the first compound between the base and the coating film.

Among these samples, in Sample No. 5, the first compound covered a part of the base, and in Sample Nos. 2, 3, and 7 to 14, the first compound covered all of the base at a position in which the coating film was present.

In all of Sample Nos. 2, 3, 5, and 7 to 14, the first compound contained 90 atm% or more of a total of Co, C, and W and contained 69 to 89 atm% of Co, 8 to 25 atm% of C, and 3 to 12 atm% of W.

Among the samples having the first compound, Sample Nos. 2, 5, and 7 to 14 in which C/hard phase was 8.0 or more had the second compound between the base and the coating film.

Among these samples, in Sample Nos. 2 and 7 to 14, the first compound surrounded the second compound.

In these samples, the second compound contained 90 atm% or more of a total of C, Co, and W and contained 60 to 75 atm% of C, 18 to 30 atm% of Co, and 2 to 10 atm% of W.

Among the samples having the first compound, Sample Nos. 3, 5, and 8 in which the TiCl₄ concentration was 1.0 mol% or more in the deposition condition for the TiN film had the third compound between the base and the coating film.

Among these samples, in Sample Nos. 3 and 8, the third compound was positioned between the first compound and the coating layer in a cross-sectional view.

The third compound contained 80 atm% or more of a total of C, Ti, and W and contained 58 to 80 atm% of C, 7 to 25 atm% of Ti, and 1 to 15 atm% of W.

The resulting insert underwent a cutting test under the following conditions.

### (Wear Resistance Test)

Workpiece material: SAPH440
Cutting speed: 1000 m/min
Feed: 0.15 mm/rev
Depth of cut: 0.25 mm
Cutting state: wet
Evaluation method: flank face wear width (µm) at the point of time when a cutting length of 5.0 km was cut

### (Chipping Resistance Test)

Workpiece material: SAPH440 with 12 grooves (10 mm wide) Cutting speed: 1000 m/min
Feed: 0.15 mm/rev
Depth of cut: 0.25 mm
Cutting state: wet
Evaluation method: the number of impacts until fracture occurred

The samples having the first compound exhibited more excellent wear resistance and chipping resistance than the samples not having the first compound.

The samples having the second compound and/or the third compound exhibited more excellent wear resistance and chipping resistance than the samples not having the second compound and/or the third compound.

The samples in which the width of TiN particles was 25 nm or less exhibited excellent wear resistance and chipping resistance.

The insert and the cutting tool including the same of the present disclosure described above are illustrated by way of example and may have a different configuration without departing from the spirit of the subject application.

### Reference Signs List

- 1: insert
- 3: base
- 5: coating film
- 5a: first layer
- 5b: second layer
- 5c: third layer
- 7: cutting edge
- 17: through-hole
- 21: first compound
- 23: second compound
- 25: third compound
- 101: cutting tool
- 103: pocket
- 105: holder
- 107: fixing screw

## Claims

1. An insert comprising a base and a coating layer covering a surface of the base, wherein
the base includes
a hard phase containing a carbonitride including Ti and
a binder phase containing Co, and
a first compound that contains Co, C, and W whose contents in atm% satisfy a relation of Co > C > W is positioned between the base and the coating layer.

2. The insert according to claim 1, wherein the first compound contains 90 atm% or more of a total of the Co, the C, and the W, and contains 69 to 89 atm% of the Co, 8 to 25 atm% of the C, and 3 to 12 atm% of the W.

3. The insert according to claim 1 or 2, wherein the first compound covers 80% or more of the base in a part in which a coating layer 5 is present.

4. The insert according to any one of claims 1 to 3, wherein a second compound that contains C, Co, and W whose contents in atm% satisfy a relation of C > Co > W is positioned between the base and the coating layer.

5. The insert according to claim 4, wherein the second compound contains 90 atm% or more of a total of the C, the Co, and the W, and contains 60 to 75 atm% of the C, 18 to 30 atm% of the Co, and 2 to 10 atm% of the W.

6. The insert according to claim 4 or 5, wherein the first compound surrounds the second compound in a cross section orthogonal to a surface of the base.

7. The insert according to any one of claims 1 to 6, wherein a third compound that contains C, Ti, and W whose contents in atm% satisfy a relation of C > Ti > W is positioned between the base and the coating layer.

8. The insert according to claim 7, wherein the third compound is positioned between the first compound and the coating layer in a cross section orthogonal to a surface of the base.

9. The insert according to claim 7 or 8, wherein the third compound contains 80 atm% or more of a total of the C, the Ti, and the W, and contains 58 to 80 atm% of the C, 7 to 25 atm% of the Ti, and 1 to 15 atm% of the W.

10. The insert according to any one of claims 1 to 9, wherein
the base includes
a hard phase of a carbonitride including Ti and
a binder phase including at least one of Co and Ni,
the base has a thermal expansion coefficient at 25 to 1000°C of 9.0 × 10⁻⁶/°C or more,
the coating layer includes
a first layer containing TiN,
a second layer positioned on the first layer and containing TiCN, and
a third layer positioned on the second layer and containing Al₂O₃,
the two layers have a compressive stress of 250 to 500 MPa, and
the three layers have a thickness of 2 µm or more and a compressive stress of 450 MPa or more, and a value of the compressive stress thereof is greater than the compressive stress of the second layer.

11. The insert according to claim 10, wherein the third layer has a thickness of 2.5 µm or more and 8.0 µm or less.

12. The insert according to claim 10 or 11, wherein the second layer has a thickness of 5 µm or more and 10 µm or less.

13. The insert according to any one of claims 10 to 12, wherein a thickness of the third layer is within a range of 0.2 to 0.4 times a sum of the thickness of the second layer and the thickness of the third layer.

14. A cutting tool comprising:
a holder extending from a first end to a second end and having a pocket on the first end side; and
the insert according to any one of claims 1 to 13 positioned in the pocket.
